# EUROPÄISCHE PATENTSCHRIFT

(11) **EP 0 461 132 B1**
(45) Veröffentlichungstag und Bekanntmachung des Hinweises auf die Patenterteilung: **11.08.1993**
(21) Anmeldenummer: 90903369.8
(22) Anmeldetag: 22.02.1990
(51) Int. Cl.: G11B 11/10, H03K 17/66, G11B 5/02

(54) **SCHALTUNGSANORDNUNG ZUR UMKEHRUNG EINES MAGNETFELDES**
CIRCUIT ARRANGEMENT FOR REVERSING A MAGNETIC FIELD
CIRCUIT POUR INVERSER UN CHAMP MAGNETIQUE

(30) Priorität: 04.03.1989 DE 3907057
(43) Veröffentlichungstag der Anmeldung: 18.12.1991
(73) Patentinhaber: Deutsche Thomson-Brandt GmbH, 78003 Villingen-Schwenningen (DE)
(72) Erfinder: ZUCKER, Friedhelm, D-7730 Villingen-Schwenningen (DE)
(86) Internationale Anmeldenummer: EP9000297
(87) Internationale Veröffentlichungsnummer: WO9010290

(56) Entgegenhaltungen:
- EP-A- 164 745
- EP-A- 312 143
- GB-A- 2 184 625
- Markus Modern Electronic Circuits Reference Manual p.759

## Beschreibung

Die Erfindung betrifft eine Schaltungsanordnung zur Umkehrung eines Magnetfeldes.

Derartige Schaltungsanordnungen werden z.B. in magneto-optischen Aufzeichnungs- und Wiedergabegeräten eingesetzt, um die Magnetisierungsrichtung in der magnetischen Schicht eines magneto-optischen Aufzeichnungsträgers umzukehren.

Ein bekannter magneto-optischer Aufzeichnungsträger ist die magneto-optische Platte, bei der hinter einer lichtdurchlässigen Schicht eine magneto-optische Schicht liegt, auf der Daten aufzeichenbar und von der diese Daten lesbar sind. Es wird zunächst erläutert, wie die Daten auf eine magneto-optische Platte geschrieben werden.

Mittels eines auf die Platte fokussierten Laserstrahls wird die magneto-optische Schicht auf eine Temperatur erhitzt, die in der Nähe der Curie-Temperatur liegt. Meist genügt es jedoch, die magneto-optische Schicht nur etwa bis zur Kompensationstemperatur aufzuheizen, die unter der Curie-Temperatur liegt. Hinter dem Brennpunkt auf der Platte ist ein Elektromagnet angeordnet, der den vom Laserstrahl erhitzten Bereich in die eine oder andere Magnetisierungsrichtung magnetisiert. Weil nach Abschalten des Laserstrahls die erhitzte Stelle wieder unter die Kompensationstemperatur abkühlt, bleibt die vom Elektromagneten festgelegte Magnetisierungsrichtung erhalten. Sie friert sozusagen ein. Auf diese Weise werden die einzelnen Bits in Domänen unterschiedlicher Magnetisierungsrichtung gespeichert. Dabei entspricht z.B. die eine Magnetisierungsrichtung einer Domäne einer logischen Eins, während die entgegengesetzte Magnetisierungsrichtung eine logische Null darstellt.

Zum Lesen der Daten macht man sich den Kerr-Effekt zunutze. Die Polarisationsebene eines linear polarisierten Lichtstrahls wird bei der Reflexion an einem magnetisierten Spiegel um einen meßbaren Winkel gedreht. Je nachdem, in welche Richtung der Spiegel magnetisiert ist, wird die Polarisationsebene des reflektierten Lichtstrahls nach rechts oder links gedreht. Weil aber die einzelnen Domänen auf der Platte wie magnetisierte Spiegel wirken, wird die Polarisationsebene eines abtastenden Lichtstrahls je nach der Magnetisierungsrichtung der gerade abgetasteten Domäne um einen meßbaren Winkel nach links oder rechts gedreht.

Aus der Drehung der Polarisationsebene des von der Platte reflektierten Lichtstrahls erkennt die optische Abtastvorrichtung, welches Bit vorliegt, eine logische Eins oder eine logische Null.

Eine bekannte Lösung, um die magneto-optische Schicht in die eine oder andere Richtung zu magnetisieren, sieht eine als Elektromagnet wirkende Schaltungsanordnung mit einer Spule hinter der magneto-optischen Platte vor. Die Spule ist so zu dimensionieren, daß sie den gesamten Bereich, den die optische Abtastvorrichtung überstreicht, umzumagnetisieren vermag. Dieser Bereich ist je nach Typ des Aufzeichnungs- und Wiedergabegerätes z.B. ein radialer oder kreisbogenförmiger Streifen, der vom Plattenrand zum Plattenmittelpunkt verläuft. Weil die Feldstärke auf dem gesamten Streifen einen Mindestwert erreichen muß, um den Streifen ummagnetisieren zu können, fallen der Querschnitt und damit die Induktivität der Spule relativ groß aus.

Bei einer weiteren bekannten Lösung ist die Spule auf der optischen Abtastvorrichtung befestigt. Die Spule kann z.B. um die Objektivlinse der optischen Abtastvorrichtung gewickelt sein. Weil bei dieser Lösung die Spule zusammen mit der optischen Abtastvorrichtung mittels eines Spurregelkreises entlang den Datenspuren auf der magneto-optischen Platte geführt wird, genügen ein geringerer Querschnitt und somit eine kleinere Induktivität, um dieselbe Mindestfeldstärke zu erzeugen, denn es wird nicht ein radialer oder kreisbogenförmiger Streifen, sondern nur ein kleiner beispielsweise kreisförmiger Bereich mit dem nahezu punktförmigen Laserfleck als Mittelpunkt in der magneto-optischen Schicht ummagnetisiert.

Aus der GB-A-2 184 625 ist eine Schaltungsanordnung zur schnellen Umkehrung eines Magnetfeldes bekannt.

Eine Reihenschaltung aus einer ersten und einer zweiten Diode, eine Reihenschaltung aus einer dritten und einer vierten Diode sowie eine Gleichspannungsquelle liegen zueinander parallel. Der gemeinsame Anschluß der ersten und der zweiten Diode ist über eine Spule mit dem gemeinsamen Anschluß der dritten und vierten Diode verbunden. Jede der ersten bis vierten Diode, die alle in Sperrichtung zur Gleichspannungsquelle gepolt sind, ist von je einem steuerbaren Schalter überbrückt. Zwischen dem gemeinsamen Anschlußpunkt der ersten und dritten Diode und der Gleichspannungsquelle liegt eine fünfte Diode, die in Durchlaßrichtung zur Gleichspannungsquelle gepolt ist. Parallel zur Gleichspannungsquelle ist eine Kapazität vorgesehen.

Obwohl diese Schaltungsanordnung eine schnelle Umkehrung des Magnetfeldes der Spule erzielt, läßt sich durch geeignete Maßnahmen die Zeit für die Umkehrung des Magnetfeldes noch weiter verkürzen.

Es ist daher Aufgabe der Erfindung, eine Schaltungsanordnung gemäß Oberbegriff des Anspruchs 1 so zu gestalen, daß eine sichere und schnelle Umkehrung des Magnetfeldes bewirkt wird.

Die Erfindung löst diese Aufgabe mit den im Anspruch 1 angegebenen Merkmalen.

Es zeigen
- Figur 1 bis Figur 4: ein erstes Ausführungsbeispiel in verschiedenen Schaltzuständen
- Figur 5: ein zweites Ausführungsbeispiel
- Figur 6: ein Ausführungsbeispiel einer Steuerschaltung zur Ansteuerung der steuerbaren Schalter
- Figur 7: ein Diagramm, in dem die Steuersignale für die steuerbaren Schalter sowie der Strom- und Spannungsverlauf an der Spule über der Zeit aufgetragen sind.

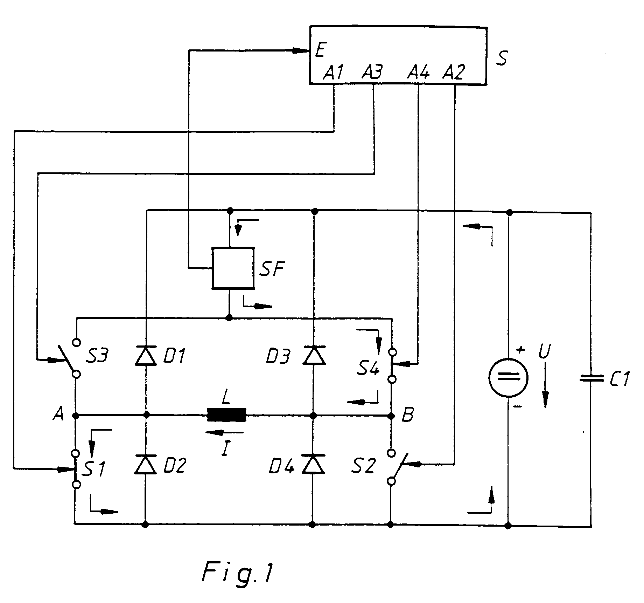

Anhand der Figuren 1 bis 4 wird nun die Erfindung beschrieben und erläutert.

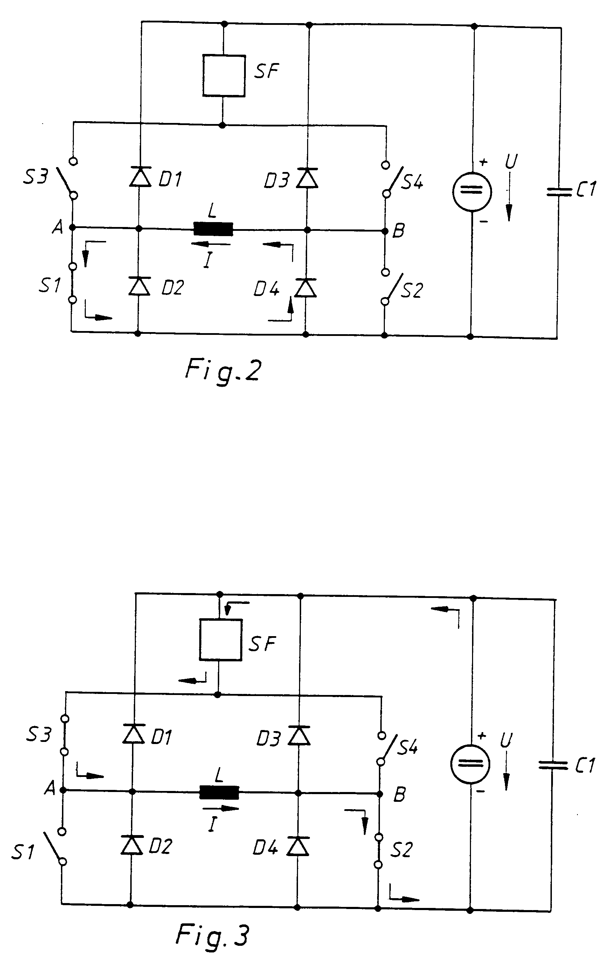

In der Figur 1 liegen eine Reihenschaltung aus zwei Dioden D1 und D2, eine Reihenschaltung aus zwei Dioden D3 und D4, eine Gleichspannungsquelle U und eine Kapazität C1 zueinander parallel. Der gemeinsame Anschlußpunkt A der Dioden D1 und D2 ist über eine Spule L mit dem gemeinsamen Anschluß B der Dioden D3 und D4 verbunden. Die Diode D2 ist von einem steuerbaren Schalter S1, die Diode D4 von einem steuerbaren Schalter S2 überbrückt. Der gemeinsame Anschluß A der Dioden D1 und D2, des steuerbaren Schalters S1 und der Spule L ist über einen steuerbaren Schalter S3 mit dem einen Anschluß eines Stromfühlers SF verbunden. Der gemeinsame Anschluß B der Dioden D3 und D4, des steuerbaren Schalters S2 und der Spule L ist über einen steuerbaren Schalter S4 ebenfalls mit dem einen Anschluß des Stromfühlers SF verbunden, dessen anderer Anschluß mit dem gemeinsamen Verbindungspunkt der Dioden D1 und D3, der Gleichspannungsquelle U und der Kapazität C1 verbunden ist. Die Ausgänge A1 bis A4 einer Steuerschaltung S, deren Eingang E mit dem Ausgang des Stromfühlers SF verbunden ist, sind mit den Steuereingängen der steuerbaren Schalter S1 bis S4 verbunden. Der Stromfühler SF kann z.B. als Schwellwertdetektor ausgeführt sein. Der besseren übersichtlichkeit wegen ist die Steuerschaltung S in den Figuren 2 bis 4 weggelassen.

In welcher Reihenfolge die Steuerschaltung S die steuerbaren Schalter S1 bis S4 öffnet und schließt, um die Umkehrung des von der Spule L erzeugten Magnetfeldes zu erzielen, wird nun anhand der Figuren 1 bis 4 erläutert.

In der Figur 1 sind die steuerbaren Schalter S1 und S4 geschlossen, während die steuerbaren Schalter S2 und S3 geöffnet sind. Es beginnt daher ein Strom I vom positiven Pol der Gleichspannungsquelle U über den Stromfühler SF, den steuerbaren Schalter S4, die Spule L und den steuerbaren Schalter S1 zum negativen Pol der Gleichspannungsquelle U zu fließen. Sobald dieser rasch ansteigende Strom einen vorgegebenen Schwellwert erreicht, gibt der Stromfühler SF ein Signal an die Steuerschaltung S ab, die nun bewirkt, daß der steuerbare Schalter S4 geöffnet wird. Daher fällt das Potential am Knoten B steil nach unten, bis schließlich die Diode D4 zu leiten beginnt.

In diesem Schaltzustand, der in Figur 2 gezeigt ist, fließt der Strom I in der gleichen Richtung weiter durch die Spule L in der Schleife, welche die Spule L, der steuerbare Schalter S1 und die Diode D4 bilden.

Zur Umkehrung des Magnetfeldes werden, wie in Figur 3 dargestellt ist, die steuerbaren Schalter S2 und S3 geschlossen, der steuerbare Schalter S1 dagegen geöffnet. Die Spannung am Knoten A schnellt nun nach oben, so daß der Strom I jetzt vom positiven Pol der Gleichspannungsquelle U über den Stromfühler SF, den steuerbaren Schalter S3, die Spule L und den steuerbaren Schalter S2 zum negativen Pol der Gleichspannungsquelle U fließt. Sobald der Strom I den vorgegebenen Schwellwert erreicht, gibt der Stromfühler SF ein Signal an die Steuerschaltung S ab, die den steuerbaren Schalter S3 öffnet. Weil die Spannung am Knoten A sprungartig sinkt, beginnt die Diode D2 zu leiten.

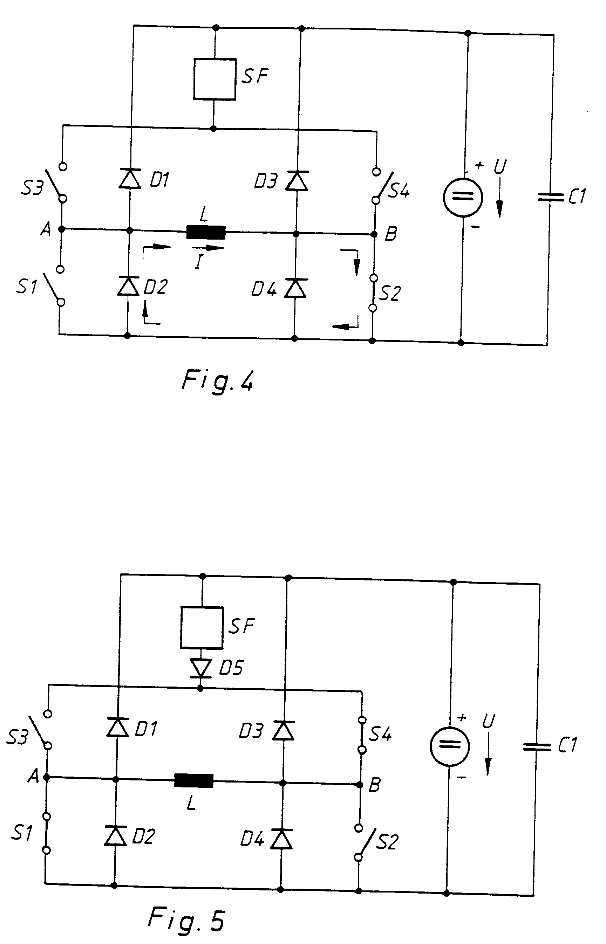

In diesem Schaltzustand, der in Figur 4 abgebildet ist, fließt der Strom I in der gleichen Richtung weiter durch die Spule L in der Schleife, die von der Spule L, der Diode D2 und dem steuerbaren Schalter S2 gebildet wird.

Um die Richtung des Magnetfeldes wieder umzukehren, wird der steuerbare Schalter S2 geöffnet, die steuerbaren Schalter S1 und S4 werden dagegen geschlossen. Es ist nun wieder der in Figur 1 gezeigte Schaltzustand erreicht.

Um z.B die Richtung des Magnetfeldes zyklisch umzukehren, werden die anhand der Figuren 1 bis 4 erläuterten Schaltvorgänge von der Steuerschaltung S zyklisch wiederholt.

Ein wesentlicher Vorteil der Erfindung liegt darin, daß die Spannung der Gleichspannungsquelle U sehr groß - bis zu einigen Hundert Volt - gewählt werden kann. Wegen der hohen Spannung läßt sich eine sehr schnelle Umkehr des Stromes und dadurch auch des Magnetfeldes erzielen. Trotz der hohen Spannung verbraucht die erfindungsgemäße Schaltungsanordnung aber nur wenig Energie, denn bei der Umkehrung der Stromrichtung gibt die Spule L die in ihr gespeicherte Energie wieder an die Spannungsquelle U oder an die parallel geschaltete Kapazität C1 ab.

In der Figur 5 ist ein erstes Ausführungsbeispiel der Erfindung abgebildet, das sich von der Schaltungsanordnung aus Figur 1 dadurch unterscheidet, daß in einem Anschlußzweig des Stromfühlers eine Diode D5 liegt. Diese Diode D5 verhindert, daß der Strom in der falschen Richtung durch den Stromfühler SF fließen kann.

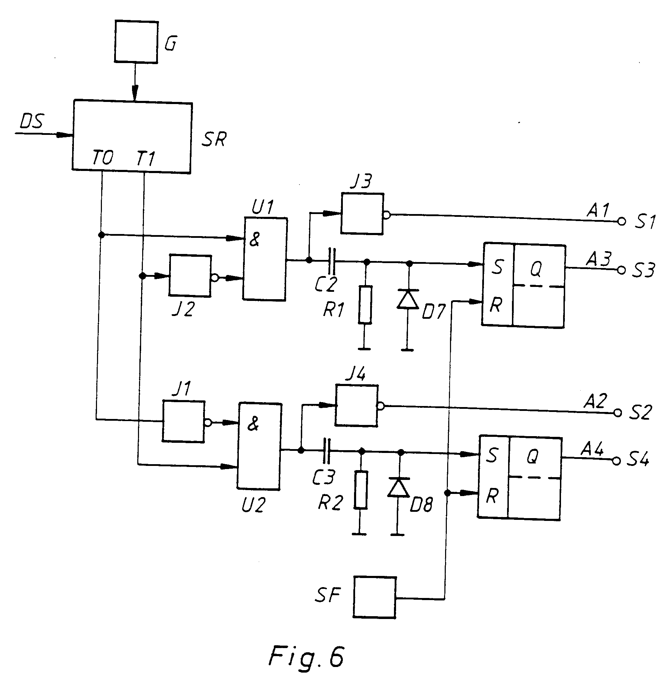

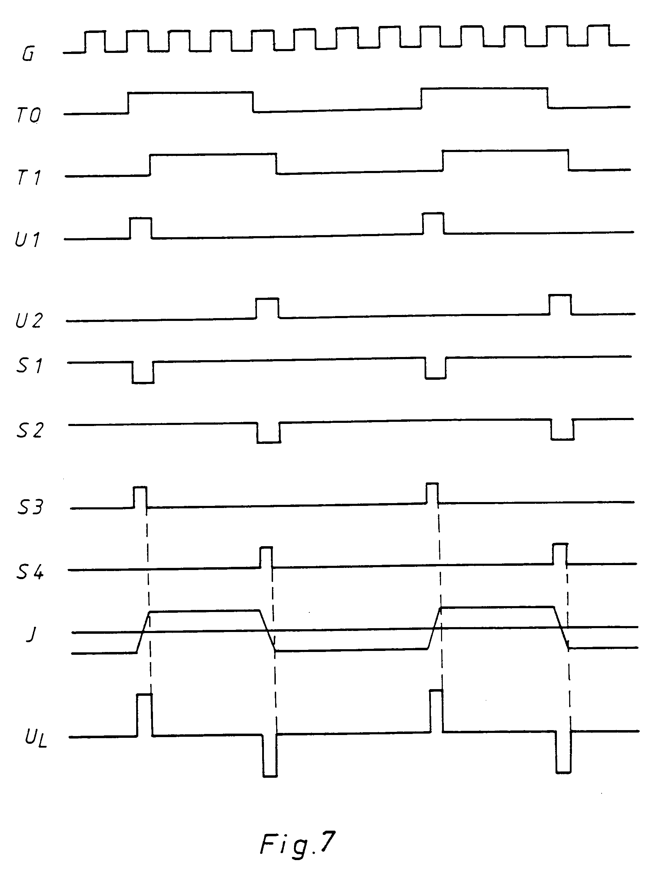

Das in der Figur 6 gezeigte Ausführungsbeispiel einer Steuerschaltung zur Ansteuerung der steuerbaren Schalter S1 bis S4 wird zunächst beschrieben und anschließend mit Hilfe des in Figur 7 gezeigten Impulsdiagrammes erläutert.

Wie bereits erwähnt, ist die Erfindung zum Ummagnetisieren der Magnetschicht eines magneto-optischen Aufzeichnungsträgers geeignet.

Das auf eine magneto-optische Platte aufzuzeichnende digitale Datensignal DS wird dem Dateneingang eines Schieberegisters SR zugeführt, das von einem Taktgenerator G getaktet wird. Der erste Ausgang T0 des Schieberegisters SR, an dem das unverzögerte Datensignal abnehmbar ist, ist mit dem ersten Eingang eines UND-Gatters U1 und über einen ersten Inverter 11 mit dem ersten Eingang eines UND-Gatters U2 verbunden. Der zweite Ausgang T1 des Schieberegisters SR, an dem das um einen Takt verzögerte Datensignal abnehmbar ist, ist mit dem zweiten Eingang des UND-Gatters U2 und über einen Inverter I2 mit dem zweiten Eingang des UND-Gatters U1 verbunden. Der Ausgang des UND-Gatters U1 ist mit dem Eingang eines Inverters I3 und über eine Kapazität C2 mit dem Setzeingang eines RS-Flip-Flops F1 verbunden. Der Ausgang des UND-Gatters U2 ist mit dem Eingang eines Inverters 14 und über eine Kapazität C3 mit dem Setzeingang eines RS-Flip-Flops F2 verbunden. Die Setzeingänge der beiden RS-Flip-Flops F1 und F2 liegen über je eine Parallelschaltung aus einem Widerstand R1 bzw. R2 und einer Diode D6 bzw. D7 auf Bezugspotential. Der Ausgang des Stromfühlers SF ist mit dem Rücksetzeingang der beiden RS-Flip-Flops F1 und F2 verbunden. Am Ausgang des Inverters I3 ist das Steuersignal für den steuerbaren Schalter S1, am Ausgang des Inverters I4 das Steuersignal für den steuerbaren Schalter S2, am Q-Ausgang des RS-Flip-Flops F1 das Steuersignal für den steuerbaren Schalter S3 und schließlich am Q-Ausgang des RS-Flip-Flops F2 das Steuersignal für den steuerbaren Schalter S4 abnehmbar.

Das aus dem Widerstand R1 und der Kapazität C2 gebildete Differenzierglied dient dazu, die Impulse am Ausgang des UND-Gatters U1 zu verkürzen. Ebenso werden die Impulse am Ausgang des UND-Gatters U2 durch das Differenzierglied aus dem Widerstand R2 und der Kapazität C2 verkürzt. Die Dioden D6 und D7 verhindern, daß auch die fallenden Flanken differenziert werden, wenn das Signal am Ausgang der beiden UND-Gatter U1 und U2 von "HIGH" auf "LOW" übergeht. Die von den beiden Differenziergliedern bewirkte Verkürzung der Impulse an den Ausgängen der beiden UND-Gatter U1 und U2 ist erforderlich, damit die Setzeingänge der beiden RS-Flip-Flops F1 und F2 stets auf "LOW" liegen, wenn die RS-Flip-Flops vom Stromfühler SF einen Rücksetzimpuls erhalten.

Das Impulsdiagramm in der Figur 7 zeigt den Takt G für das Schieberegister SR, das unverzögerte Datensignal DS und das um einen Takt verzögerte Datensignal TS. Bei jeder Flanke im Datensignal DS ist die Richtung des Stromes I, der durch die Spule L fließt, umzukehren. Das UND-Gatter U1 gibt nun bei jeder steigenden Flanke im Datensignal DS einen Impuls ab, der vom Inverter I3 invertiert den steuerbaren Schalter S1 für die Dauer des Impulses öffnet. Weil gleichzeitig das RS-Flip-Flop F1 vom Impuls am Ausgang des UND-Gatters U1 gesetzt wird, wird der steuerbare Schalter S3 geschlossen. Sobald aber der Betrag des Stromes I durch die Spule L den vorgegebenen Schwellwert erreicht, wird das RS-Flip-Flop F1 vom Stromfühler SF zurückgesetzt und dadurch der steuerbare Schalter S3 wieder geöffnet.

Bei jeder fallenden Flanke im Datensignal DS gibt das UND-Gatter U2 einen Impuls ab, der vom Inverter I4 invertiert den steuerbaren Schalter S2 für die Dauer des Impulses öffnet. Gleichzeitig wird der steuerbare Schalter S4 geschlossen, weil das RS-Flip-Flop F2 vom Impuls am Ausgang des UND-Gatters U2 gesetzt wird. Erreicht der Betrag des Stromes I durch die Spule L den vorgegebenen Schwellwert, so setzt der Stromfühler SF das RS-Flip-Flop F2 zurück, damit der steuerbare Schalter S4 wieder geöffnet wird. Die an der Spule L abfallende Spannung U_{L} steigt bei jeder steigenden Flanke im Datensignal DS impulsförmig an, bei einer fallenden Flanke nimmt sie dagegen die Form eines negativen Impulses an. Der Strom I durch die Spule L ändert in Abhängigkeit vom Datensignal DS Betrag und Richtung: Bei einer steigenden Flanke im Datensignal DS steigt der Strom I, der durch die Spule L fließt vom unteren Schwellwert rasch auf den oberen an, während er bei einer fallenden Flanke ebenso schnell vom oberen Schwellwert auf den betragsgleichen unteren Schwellwert sinkt. Der den Stromfühler SF durchfließende Strom ändert in Abhängigkeit vom Datensignal DS nur seinen Betrag, seine Richtung behält er aber stets bei. Bei jeder Flanke im Datensignal DS steigt er rasch auf den am Stromfühler SF, einem Schwellwertdetektor, eingestellten Schwellwert an, um dann schlagartig auf den Wert Null zu sinken.

Die Erfindung bietet bei magneto-optischen Aufzeichnungs- und Wiedergabegeräten den Vorteil, daß bereits auf der magneto-optischen Platte aufgezeichnete Daten unmittelbar überschrieben werden können. Dagegen werden bei bekannten magneto-optischen Aufzeichnungs- und Wiedergabegeräten zuerst die alten Daten gelöscht, ehe neue Daten aufgezeichnet werden.

Zu diesem Zweck wird die magneto-optische Schicht an den Stellen, wo die neuen Daten gespeichert werden sollen, vom Laser auf die Kompensationstemperatur erhitzt. Dadurch werden diese Stellen in die eine Richtung magnetisiert. Die Platte wird initialisiert, wie der Fachausdruck für diesen Vorgang lautet. Anschließend wird die Richtung des in der Spule erzeugten Magnetfeldes wieder umgekehrt.

Zum Aufzeichnen der neuen Daten wird die Laserleistung zwischen einem kleinen und großen Wert in Abhängigkeit vom zu speichernden Bit geschaltet. Wird an der zuvor gelöschten Stelle beispielsweise eine logische Null gespeichert, so arbeitet der Laser mit der kleinen Leistung, damit die Kompensationstemperatur nicht erreicht wird. Zum Aufzeichnen einer logischen Eins erhitzt der Laser dagegen die neu zu beschreibende Stelle auf die Kompensationstemperatur, damit diese Stelle von der Spule ummagnetisiert werden kann. Auf diese umständliche Weise werden Daten auf der magneto-optischen Platte zuerst gelöscht, ehe anschließend die neuen Daten aufgezeichnet werden.

Die Erfindung ist nicht nur für magneto-optische Geräte, sondern auch für andere magnetische Aufzeichnungsgeräte geeignet.

## Patentansprüche

1. Schaltungsanordnung zur Umkehrung eines Magnetfeldes, bei der eine Reihenschaltung aus einer ersten und einer zweiten Diode (D1, D2), eine Reihenschaltung aus einer dritter und vierten Diode (D3, D4) und eine Gleichspannungsquelle (U) zueinander parallel liegen, wobei der gemeinsame Anschluß (A) der ersten und zweiten Diode (D1, D2) über eine Spule (L) mit dem gemeinsamen Anschluß (B) der dritten und vierten Diode (D3, D4) verbunden ist, wobei die zweite Diode (D2) von einem ersten steuerbaren Schalter (S1) und die vierte Diode (D4) von einem zweiten steuerbaren Schalter (S2) überbrückt ist, wobei der eine Anschluß (A) der Spule (L) über einen dritten steuerbaren Schalter (S3) und der andere Anschluß (B) über einen vierten steuerbaren Schalter (S4) miteinander verbunden sind und wobei alle Dioden (D1, D2, D3, D4) in Sperrichtung zur Gleichspannungsquelle (U) gepolt sind, **dadurch gekennzeichnet,** daß zwischen dem gemeinsamen Verbindungspunkt der ersten und dritten Diode (D1, D3) und dem gemeinsamen Verbindungspunkt des dritten und vierten steuerbaren Schalters (S3, S4) ein Stromfühler (SF) liegt, dessen Ausgang mit dem Eingang (E) einer Steuerschaltung (S) verbunden ist, deren Ausgänge (A1, A2, A3, A4) mit den Steuereingängen der steuerbaren Schalter (S1, S2, S3, S4) verbunden sind, und von der die Schalter derart steuerbar sind, daß in einem ersten Verfahrensschritt der erste und der vierte steuerbare Schalter (S1, S4) geschlossen werden, während der zweite und dritte steuerbare Schalter (S2, S3) geöffnet werden, daß in einem zweiten Verfahrensschritt der vierte steuerbare Schalter (S4) geöffnet wird, wenn der Betrag des Stromes (I) durch die Spule (L) einen vorgebbaren Schwellwert überschreitet, daß in einem dritten Verfahrensschritt zur Umkehr des Stromes in der Spule (L) der erste steuerbare Schalter (S1) geöffnet, der zweite und dritte steuerbare Schalter (S2, S3) dagegen geschlossen werden, daß in einem vierten Verfahrensschritt der dritte steuerbare Schalter (S3) geöffnet wird, wenn der Betrag des Stromes (I) durch die Spule (L) den vorgebbaren Schwellwert überschreitet, und daß zur Umkehr des Stromes (I) durch die Spule (L) in einem fünften Verfahrensschritt der zweite steuerbare Schalter (S2) geöffnet wird, der erste und der vierte steuerbare Schalter (S1, S4) dagegen geschlossen werden.

2. Schaltungsanordnung nach Anspruch 1, **dadurch gekennzeichnet,** daß zur zyklischen Umkehr des Stromes (I) durch die Spule (L) die Verfahrensschritte zwei bis fünf zyklisch von der Steuerschaltung (S) wiederholt werden.

3. Schaltungsanordnung nach Anspruch 1 oder 2, **dadurch gekennzeichnet**, daß eine erste Kapazität (C1) parallel zur Gleichspannungsquelle (U) geschaltet ist.

4. Schaltungsanordnung nach Anspruch 1, 2 oder 3, **dadurch gekennzeichnet,** daß in einem Anschlußzweig des Stromfühlers (SF) eine fünfte Diode (D5) liegt, die für die Gleichspannungsquelle (U) in Durchlaßrichtung gepolt ist.

5. Schaltungsanordnung nach Anspruch 1, 2, 3 oder 4, **dadurch gekennzeichnet,** daß ein Schwellwertdetektor als Stromfühler (SF) vorgesehen ist.

6. Schaltungsanordnung nach Anspruch 1, 2, 3, 4 oder 5, **dadurch gekennzeichnet,** daß ein digitales Signal (DS) am Eingang eines Schieberegisters (SR) liegt, das von einem Taktgenerator (G) getaktet wird, daß die Signale an den Ausgängen (T0, T1) des Schieberegisters und das Ausgangssignal des Stromfühlers (SF) in einer logischen Schaltung miteinander verknüpft werden und daß an den Ausgängen der logischen Schaltung die Steuersignale für die steuerbaren Schalter (S1, S2, S3, S4) abnehmbar sind.

7. Schaltungsanordnung nach Anspruch 6, **dadurch gekennzeichnet,** daß der erste Ausgang (T0) des Schieberegisters (SR) mit dem ersten Eingang eines ersten UND-Gatters (U1) und über einen ersten Inverter (I1) mit dem ersten Eingang eines zweiten UND-Gatters (U2) verbunden ist, daß der zweite Ausgang (T1) des Schieberegisters (SR) mit dem zweiten Eingang des zweiten UND-Gatters (U2) und über einen zweiten Inverter (I2) mit dem zweiten Eingang des ersten UND-Gatters (U1) verbunden ist, daß der Ausgang des ersten UND-Gatters (U1) mit dem Eingang eines dritten Inverters (I3) und über eine zweite Kapazität (C2) mit dem Setzeingang eines ersten RS-Flip-Flops (F1) verbunden ist, daß der Ausgang des zweiten UND-Gatters (U2) mit dem Eingang eines vierten Inverters (T4) und über eine dritte Kapazität (C3) mit dem Setzeingang eines zweiten RS-Flip-Flops (F2) verbunden ist, daß der Setzeingang des ersten RS-Flip-Flops (F1) über eine Parallelschaltung aus einem ersten Widerstand (R1) und einer sechsten Diode (D6) auf Bezugspotential liegt, daß der Setzeingang des zweiten RS-Flip-Flops (F2) über eine Parallelschaltung aus einem zweiten Widerstand (R2) und einer siebten Diode (D7) auf Bezugspotential liegt, daß der Ausgang des Stromfühlers (SF) mit dem Rücksetzeingang des ersten und zweiten RS-Flip-Flops (F1, F2) verbunden ist, daß der Ausgang des dritten Inverters (I3) mit dem Steuereingang des ersten steuerbaren Schalters (S1) verbunden ist, daß der Ausgang des vierten Inverters (I4) mit dem Steuereingang des zweiten steuerbaren Schalters (S2) verbunden ist, daß der Q-Ausgang des ersten RS-Flip-Flops mit dem Steuereingang des dritten steuerbaren Schalters (S3) verbunden ist und daß der Q-Ausgang des zweiten RS-Flip-Flops (F2) mit dem Steuereingang des vierten steuerbaren Schalters (S4) verbunden ist.

## Claims

1. A circuit arrangement for the reversal of a magnetic field, in which a series circuit consisting of a first and a second diode (D1,D2), a series circuit consisting of a third and fourth diodes (D3,D4) and a DC voltage source (U) are connected in parallel, in which the common connection (L) of the first and second diodes (D1,D2) is connected via a coil (L) with the common connection (B) of the third and fourth diodes (D3,D4), in which the second diode (D2) is shunted by a first controllable switch (S1) and the fourth diode (D4) in shunted by a second controllable switch (S2), in which, by means of a third controllable switch (S3), the first connection point (A) of the coil (L) and, via a fourth controllable switch (S4), the other connection point (B) are connected to each other and in which all diodes (D1,D2,D3,D4), are biassed in the reverse direction to the DC voltage source (U), characterised in that between the common connection point of the first and third diodes (D1,D3), and the common connection point of the third and fourth controllable switches (S3,S4), there is connected a current sensor (SF) the output of which is connected to the input (E) of a control circuit (S), the outputs (A1,A2,A3,A4) of which are connected to the control inputs of the controllable switches (S1,S2,S3,S4), and by which the switches are controllable such that in a first process step the first and the fourth controllable switches (S1,S4) are closed while the second and third controllable switches (S2,S3) are open, that in a second process step the fourth controllable switch (S4) is open, when the magnitude of the current (I) through the coil (L) exceeds a predetermined threshold value, that in a third process step for reversal of the current in the coil (L) the first controllable switch (S1) is open and the second and third controllable switches (S2,S3) in contrast are closed, that in a fourth process step the third controllable switch (S3) is open when the magnitude of the current (I) through the coil (L) lies below the predetermined threshold value, and that for reversal of the current (I) through the coil (L) in a fifth process step the second controllable switch (S2) is open and the first and the fourth controllable switches (S1,S4) in contrast are closed.

2. A circuit arrangement according to claim 1, characterised in that for the cyclical reversal of the current (I) through the coil (L) the process steps two to five are cyclically repeated by the control circuit (S).

3. A circuit arrangement according to claim 1 or 2, characterised in that a first capacitor (C1) is connected in parallel to the DC voltage source (U).

4. A circuit arrangement according to claim 1,2 or 3, characterised in that in a connection branch of the current sensor (SF) there is connected a fifth diode (D5) which is biased in the forward direction for the DC voltage source (U).

5. A circuit arrangement according to claim 1,2,3 or 4, characterised in that a threshold value detector is provided as a current sensor (SF).

6. A circuit arrangement according to claim 1,2,3,4 or 5, characterised in that a digital signal (DS) is connected to the input of a shift register (SR), which is clocked by a clock generator (G), that the signals at the output (T0,T1) of the shift register and the output signal of the current sensor (SF) are logically combined in a logic circuit and that at the outputs of the logic circuit there are derivable the control signals for the controllable switches (S1,S2,S3,S4).

7. A circuit arrangement according to claim 6, characterised in that the first output (T0) of the shift register (SR) is connected to the first input of a first AND-gate (U1) and via a first inverter (I1) to the first input of a second AND-gate (U2), that the second output (T1) of the shift register (SR) is connected to the second input of the second AND-gate (U2) and via a second inverter (I2) to the second input of the first AND-gate (U1), that the output of the first AND-gate (U1) is connected to the input of the third inverter (I3) and via a second capacitor (C2) to the set input of a first RS-flip-flop (F1), that the output of the second AND-gate (U2) is connected to the input of the fourth inverter (I4) and via a third capacitor (C3) to the set input of a second RS-flip-flop (F2), that the said input of the first RS-flip-flop (F1) is connected to reference potential via a parallel circuit consisting of a first resistor (R1) and a sixth diode (D6), that the said input of the second RS-flip-flop (F2) is connected to reference potential via a parallel circuit consisting of a second resistor (R2) and a seventh diode (D7), that the output of the current sensor (SF) is connected to the reset input of the first and second RS-flip-flops (F1,F2), that the output of the third inverter (I3) is connected to the control input of the first controllable switch (S1), that the output of the fourth inverter (I4) is connected to the control input of the second controllable switch (S2) that the Q-output of the first RS-flip-flop is connected to the control input of the third controllable switch (S3) and that the Q-output of the second RS-flip-flop (F2) is connected to the control input of the fourth controllable switch (S4).

## Revendications

1. Circuit pour inverser un champ magnétique dans lequel un montage en série composé d'une première et d'une seconde diode (D1, D2), un montage en série composé d'une troisième et d'une quatrième diode (D3, D4) et une source de tension continue (U) sont parallèles l'un à l'autre, la jonction commune (A) de la première et de la seconde diode (D1, D2) étant reliée par une bobine (L) à la jonction commune (B) de la troisième et de la quatrième diode (D3, D4), la seconde diode (D2) étant court-circuitée par un premier commutateur qui peut être commandé (S1) et la quatrième diode (D4) par un second commutateur qui peut être commuté (S2), l'une des jonctions (A) de la bobine (L) étant reliée par un troisième commutateur qui peut être commandé (S3) à l'autre jonction (B) par un quatrième commutateur qui peut être commandé (S4) et toutes les diodes (D1, D2, D3, D4) étant polarisées dans le sens de non conduction vers la source de tension continue (U), **caractérisé en ce** qu'un détecteur de courant (SF) se trouve entre le point de jonction commun de la première et de la troisième diode (D1, D3) et le point de jonction commun du troisième et du quatrième commutateur qui peuvent être commandés (S3, S4), détecteur dont la sortie est reliée à l'entrée (E) d'un circuit de commande (S) dont les sorties (A1, A2, A3, A4) sont reliées aux entrées de commande des commutateurs qui peuvent être commandés (S1, S2, S3, S4), circuit par lequel les commutateurs peuvent être commandés de telle manière que, dans une première phase du procédé, le premier et le quatrième commutateur qui peuvent être commandés (S1, S4) se ferment, tandis que le second et le troisième commutateur qui peuvent être commandés (S2, S3) s'ouvrent, que, dans une seconde phase du procédé, le quatrième commutateur qui peut être commandé (S4) s'ouvre lorsque la valeur absolue du courant (I) qui passe par la bobine (L) dépasse une valeur de seuil qui peut être donnée, que, dans une troisième phase de procédé pour l'inversion du courant dans la bobine (L) le premier commutateur qui peut être commandé (S1) s'ouvre, mais que les second et troisième commutateurs qui peuvent être commandés (S2, S3) se ferment, que, dans une quatrième phase du procédé, le troisième commutateur qui peut être commandé (S3) s'ouvre lorsque la valeur absolue du courant (I) qui passe par la bobine (L) dépasse la valeur de seuil qui peut être donnée et que, pour l'inversion du courant (I) qui passe par la bobine (L), dans une cinquième phase du procédé le second commutateur qui peut être commandé (S2) s'ouvre et que, par contre, le premier et le quatrième commutateur qui peuvent être commandés (S1, S4) se ferment.

2. Circuit selon la revendication 1, **caractérisé en ce** que, pour l'inversion cyclique du courant (I) qui passe par la bobine (L), les phases de procédé deux à cinq sont répétées de manière cyclique par le circuit de commande (S).

3. Circuit selon la revendication 1 ou 2, **caractérisé en ce** qu'un premier condensateur (C1) est monté en parallèle avec la source de tension continue (U).

4. Circuit selon la revendication 1, 2 ou 3, **caractérisé en ce** qu'une cinquième diode (D5), qui est polarisée pour la source de tension continue (U) dans le sens de l'état passant, se trouve dans un branchement de jonction du détecteur de courant (SF).

5. Circuit selon la revendication 1, 2, 3 ou 4, **caractérisé en ce** qu'un détecteur de valeur de seuil est prévu comme détecteur de courant (SF).

6. Circuit selon la revendication 1, 2, 3, 4 ou 5, **caractérisé en ce** qu'un signal numérique (DS), qui est rythmé par un générateur de cycle (G), se trouve à l'entrée d'un registre à décalage (SR), que les signaux aux sorties (T0, T1) du registre à décalage et le signal de sortie du détecteur de courant (SF) sont enchaînés l'un à l'autre dans un circuit logique et que les signaux de commande pour les commutateurs qui peuvent être commandés (S1, S2, S3, S4) peuvent être pris aux sorties du circuit logique.

7. Circuit selon la revendication 6, **caractérisé en ce** que la première sortie (TO) du registre à décalage (SR) est reliée à la première entrée d'une première porte ET (U1) et par un premier inverseur (I1) à la première entrée d'une seconde porte ET (U2), que la seconde sortie (T1) du registre à décalage (SR) est reliée à la seconde entrée de la seconde porte ET (U2) et par un second inverseur (I2) à la seconde entrée de la première porte ET (U1), que la sortie de la première porte ET (U1) est reliée à l'entrée d'un troisième inverseur (I3) et par un second condensateur (C2) à l'entrée d'activation d'un premier flip-flop RS (F1), que la sortie de la seconde porte ET (U2) est reliée à l'entrée d'un quatrième inverseur (I4) et par un troisième condensateur (C3) à l'entrée d'activation d'un second flip-flop RS (F2), que l'entrée d'activation du premier flip-flop RS (F1) se trouve sur le potentiel de référence par un montage en parallèle constitué par une première résistance (R1) et une sixième diode (D6), que l'entrée d'activation du second flip-flop RS (F2) se trouve sur le potentiel de référence par un montage en parallèle constitué par une seconde résistance (R2) et une septième diode (D7), que la sortie du détecteur de courant (SF) est reliée à l'entrée de remise à l'état initial du premier et du second flip-flop RS (F1, F2), que la sortie du troisième inverseur (I3) est reliée à l'entrée de commande du premier commutateur qui peut être commandé (S1), que la sortie du quatrième inverseur (I4) est reliée à l'entrée de commande du second commutateur qui peut être commandé (S2), que la sortie Q du premier flip-flop RS est reliée à l'entrée de commande du troisième commutateur qui peut être commandé (S3) et que la sortie Q du second flip-flop RS (F2) est reliée à l'entrée de commande du quatrième commutateur qui peut être commandé (S4).
